Europäisches Patentamt

European Patent Office

Office européen des brevets

(11) Publication number: **0 296 973 B1**

# EUROPEAN PATENT SPECIFICATION

(45) Date of publication of patent specification: **13.04.94**  (51) Int. Cl.5: **H01L 39/24**

(21) Application number: **88401577.7**

(22) Date of filing: **22.06.88**

(54) Method for producing a superconducting circuit.

(30) Priority: **22.06.87 JP 154830/87**
**29.06.87 JP 162117/87**

(43) Date of publication of application:
**28.12.88 Bulletin 88/52**

(45) Publication of the grant of the patent:
**13.04.94 Bulletin 94/15**

(84) Designated Contracting States:
**DE FR GB**

(56) References cited:
**EP-A- 0 088 666**
**EP-A- 0 286 891**
**EP-A- 0 292 387**

**PROCEEDINGS OF SYMPOSIUM S, EX-
TENDED ABSTRACTS OF HIGH TC SUPER-
CONDUCTORS, SPRING MEETING OF THE
MATERIALS RESEARCH SOCIETY, 23rd - 24th
April 1987, pages 81-84, Anaheim, CA, US;
R.H. KOCH et al.: "Thin films and SQUIDS
made from YBa2Cu3Oy"**

**IDEM**

(73) Proprietor: **SUMITOMO ELECTRIC INDUSTRIES
LIMITED
No. 15, Kitahama 5-chome,
Higashi-ku
Osaka-shi, Osaka 541(JP)**

(72) Inventor: **Imai, Takahiro
Itami Works of
Sumitomo Electric Industries Ltd.
1-1 Koyakita 1-chome Itami-shi Hyogo(JP)**
Inventor: **Harada, Keizo
Itami Works of
Sumitomo Electric Industries Ltd.
1-1 Koyakita 1-chome Itami-shi Hyogo(JP)**
Inventor: **Yazu, Shuji
Itami Works of
Sumitomo Electric Industries Ltd.
1-1 Koyakita 1-chome Itami-shi Hyogo(JP)**
Inventor: **Jodai, Tetsuji
Itami Works of
Sumitomo Electric Industries Ltd.
1-1 Koyakita 1-chome Itami-shi Hyogo(JP)**

(74) Representative: **Ballot, Paul Denis Jacques
Cabinet Ballot-Schmit,
7, rue Le Sueur
F-75116 Paris (FR)**

EP 0 296 973 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

SOVIET PHYSICS LETTERS, J.E.T.P. LETTERS, vol. 46, no. 9, November 1987, pages 456-458, New York, US; S.V. ANTONENKO et al.: "Effect of ion irradiation on the properties of high-temperature oxide superconductors"

IDEM

JAPANESE JOURNAL OF APPLIED PHYSICS, vol. 26, supplement 26-3, 1987, pages 2141-2142; 18th Int. Conf. on Low Temperature Physics, 20th - 26th August 1987, Kyoto, JP; B. EGNER et al.: "The influence of irradiation-induced defects on the superconductivity of YBa2Cu3O7"

IDEM

APPLIED PHYSICS LETTERS, vol. 51, no. 2, 13th July 1987, pages 139-141, American Institute of Physics, New York, US; G.J. CLARK et al.: "Effects of radiation damage in ion-implanted thin films of metal-oxide superconductors"

IDEM

PHYSICS TODAY, vol. 41, no. 4, April 1988, pages 21-25, American Institute of Physics, New York, US; A. KHURANA: "The Tc to beat is 125 K"

## Description

Background of the Invention

Field of the invention

The present invention relates to a method for producing a superconducting circuit. More particularly, it relates to a method for producing a superconducting circuit pattern of compound oxide having a high critical temperature which is used in the field of electronics.

Description of the related art

The superconductivity is a phenomenon which is explained to be a phenomenon of a kind of phase change of electrons under which the electrical resistance become zero and the perfect diamagnetism is observed. Thus, under the superconducting condition, electric current of a very high current density can be delivered without any loss of power. Therefore, the power loss in circuits used in the field of electronics can be reduced greatly. It is also expected to utilize the superconductor in the field of a high sensitive sensors or detectors for sensing very weak magnetic field, microwave, radiant ray or the like.

However, the critical temperature could not exceed 23.2 K of $Nb_3Ge$ which was the the highest Tc for all studies for the past ten years.

Possibility of existence of a new type of superconducting materials having much higher Tc was revealed by Bednorz and Müller who discovered a new oxide type superconductor in 1986 [Z. Phys. B64 (1986) 189]

It had been known that certain ceramics material of compound oxides exhibit the property of superconductivity. For example, U. S. patent No. 3,932,315 discloses Ba-Pb-Bi type compound oxide which shows superconductivity and Japanese patent laid-open No. 60-173,885 discloses that Ba-Bi type compound oxides also show superconductivity. These superconductors, however, possess rather lower transition temperatures of about 10 K and hence usage of liquidized helium (boiling point of 4.2 K) as cryogen is indispensable to realize superconductivity.

The new type compound oxide superconductor discovered by Bednorz and Müller is represented by $[La, Sr]_2CuO_4$ which is called as the $K_2NiF_4$-type oxide having a crystal structure which is similar to known perovskite type oxides. The $K_2NiF_4$-type oxides show such higher Tc as 30 K which are extremely higher than known superconducting materials.

It was also reported in the news parer that C. W. Chu et al discovered in the United States of America another type of superconducting material having the critical temperature of in the order of 90 K in February 1987, and hence possibility of existence of high-temperature superconductors have burst on the scene.

However, the above mentioned new type superconducting materials which was just born and which are presumed to be classified in the perovskite crystals of La-Sr-Cu-O system and Y-Ba-Cu-O system have been studied and developed mainly in a form of sintered articles. In already known methods, the superconducting materials are compacted in a metal pipe and then are drawn into a superconducting wire or they are blended with organic binder to prepare a paste for circuit printing. These method, however, include inevitably the final sintering stage of the superconducting material shaped into a wire-form or a layered form, so that a high dimensional stability of the sintered product can not be expected due to shrinkage which occur during the sintering operation and it is difficult to produce a variety of articles having desired configuration freely and precisely. In other words, a finely patterned circuit for electronics devices can not be produced by the conventional methods.

Still more, the products do not possess satisfactory properties of superconductivity because the oxygen contents which is one of the critical factors of this type of superconductor can not be controlled or adjusted to an optimum value for realizing higher critical temperatures.

It may be also used a variety of vapour phase deposition techniques to produce a thin film of superconductor which is applicable to electric circuits having fine patterns. In fact, in these techniques, it is possible to deposit the superconducting material on a substrate to produce a fine circuit pattern by means of a masking sheet. Such superconducting circuit pattern may be produced also by the ion-etching or ion-sputtering technique in which predetermined portions of the thin film of superconductor deposited on the substrate is cut or removed to leave a circuit pattern.

However, in the conventional sputtering technique for preparing a thin film of superconductor, sputtering must be carried out in the presence of oxygen gas added in a sputtering gas and also the substrate must be heated at such a temperature that an improved crystalline structure is obtained. Still more, the resulting

EP 0 296 973 B1

sputtered film must be heat-treated in an atmosphere containing oxygen gas to increase the oxygen contents in the thin film. For example, in Japanese patent laid-open No. 56-109824 which discloses a method for preparing a thin film of superconductor represented by $BaPb_{1-x}Bi_xO_3$ (in which $0.05 \leq x \leq 0.35$), high-frequency sputtering is carried out in an oxygen containing atmosphere and then the resulting film must be further heated at 500 to 550 °C. We also described sputtering conditions for preparing superconducting thin films of compound oxide by the sputtering technique in a co-pending United States of America patent serial No. 152,714 filed on May 2, 1988.

The abovementioned conventional sputtering technique itself is satisfactory but is difficult to control the nature of gas in the atmosphere, resulting in that the crystal structure in a thin film obtained can not be controlled precisely.

Still more, it is not only difficult to perform the patterning operation of superconducting circuits easily and precisely on the thin film produced by the abovementioned sputtering technique but also impossible to provide a superconducting circuit of high quality.

Therefore, the abovementioned conventional techniques are not suitable for production of fine-patterned superconducting circuit on a substrate.

The present inventors disclosed, in a co-pending United States patent serial No. 195,147 titled " Process for manufacturing a superconductor and a method for producing a superconducting circuit " filed on May 18, 1988, a process for manufacturing a superconductor characterized in that a material composed of compound oxide is irradiated by one of ion beams selected from oxygen ion beam, inert gas ion beam and an ion beam consisting of a mixture of oxygen gas and inert gas to convert said material into a superconductor. The present invention is completed in the course of a series of experiments including the abovementioned patent application.

In proceedings of Symposium S, Extended Abstracts of high Tc superconductors, Spring Meeting of the Materials Reserad Society, 23 rd - 24th April 1987, pp. 81-84, is disclosed a method for forming a superconducting circuit comprising the steps of depositing a thin film of an YBaCuO compound oxide superconductor by physical vapour deposition, and, after heat treating, doping a selected portion of said film with arsenic or oxygen ions at energies from 0.3 to 3 MeV.

An object of the present invention is to overcome the abovementioned problems of the conventional technique and to provide a simple method for producing a fine superconducting circuit pattern having improved superconducting property on a substrate.

Summary of the Invention

A method for producing a superconducting circuit comprising the steps of
depositing a thin film of superconductor of compound oxide on a substrate
doping a selected portion on a surface of said thin film, is characterized in that said step of doping is doping with hydrogen ions in a dose of more than $1 \times 10^8$ atoms/cm$^2$ at a doping energy higher than 20 keV and up to and including 100 keV, to transform the crystal structure of the thin film at the selected portion from superconductor to non-superconductor, so that the remaining portion of the thin film which is left undoped in the condition of superconductor functions as a superconducting circuit.

The thin film of superconductor can be prepared by the conventional physical vapour deposition technique, such as sputtering, vacuum deposition, ion plating molecular beam epitaxial growth, by chemical deposition technique such as CVD and may be prepared by coating technique in which a paste of powder mixture with a binder is coated on a substrate and the resulting coated layer is sintered to prepare a sintered thin film of superconductor. For example, such superconducting thin film can be prepared by sputtering technique described in our co-pending United States of America patent serial No. 152,714 filed on May 2, 1988.

The ion to be doped in the thin film of superconductor is hydrogen ion. The energy or intensity of the ion to be doped is preferably higher than 20 KeV, and more preferably higher than 30 KeV. If the intensity of ion is not higher than 20 KeV, the ion can not penetrate satisfactorily into the thin film. The ion source may be any one of the conventional Freeman type, Kaufman type, PIG type, RF (radio-frequency) type or a microwave plasma type source.

The compound oxide which is applicable to the method according to the present invention may be a compound oxide including an element $\alpha$ selected from IIa group of the Periodic Table, an element $\beta$ selected from IIIa group of the Periodic Table copper and oxygen. A portion of these components can be substituted by at least one of elements selected from a group comprising Al, Fe, Ni, Zn, Ag and Ti.

The abovementioned oxides possess preferably perovskite type or quasi-perovskite type crystal structure. The term of quasi-perovskite type means a structure which can be considered to have such a

4

crystal structure that is similar to Perovskite-type oxides and includes an orthorhombically distorted perovskite or a distorted oxygen-deficient perovskite or the like.

According to a preferred embodiment of the present invention, the element $\alpha$ is Ba or Sr, and the element $\beta$ is at least one element selected from a group comprising Y, La, Gd, Dy, Ho, Er, Tm, Yb, Nd, Sm, Eu and Lu, so that the thin film may be Y-Ba-Cu-O system, La-Ba-Cu-O system, La-Sr-Cu-O system or the like.

The superconductor consisting of the compound oxide is represented by the general formula:

$$(\alpha_{1-x}\beta_x)Cu_yO_z$$

in which $\alpha$ and $\beta$ means the same definition as above, x is an atomic ratio of $\beta$ with respect to $(\alpha+\beta)$ and has a range of $0.1 \leq x \leq 0.9$, and y and z are respective atomic ratios with respect to $(\alpha_{1-x}\beta_x)$ which is considered to be equal to 1 and each satisfy ranges of $0.4 \leq y \leq 3.0$ and $1 \leq z \leq 5$ respectively, and include the following special systems:

$Y_1Ba_2Cu_3O_{7-x}$, $Ho_1Ba_2Cu_3O_{7-x}$, $Lu_1Ba_2Cu_3O_{7-x}$,
$Sm_1Ba_2Cu_3O_{7-x}$, $Nd_1Ba_2Cu_3O_{7-x}$, $Gd_1Ba_2Cu_3O_{7-x}$,
$Eu_1Ba_2Cu_3O_{7-x}$, $Er_1Ba_2Cu_3O_{7-x}$, $Dy_1Ba_2Cu_3O_{7-x}$,
$Tm_1Ba_2Cu_3O_{7-x}$, $Yb_1Ba_2Cu_3O_{7-x}$, $La_1Ba_2Cu_3O_{7-x}$,
$(La, Sr)_2CuO_{4-x}$

in which x is a number which satisfies a range of $0 < x < 1$.

The element $\alpha$ may be a combination of more than two elements selected from IIa group of the Periodic Table, the element $\beta$ may be a combination of more than two elements selected from IIIa group of the Periodic Table. It may be mentioned such combination as a system consisting of Ba, Y, Cu and at least one element selected from a group comprising Al, Fe, Ni, Zn, Ag and Ti, a system consisting of Ba, La, Cu and at least one element selected from a group comprising Al, Fe, Ni, Zn, Ag and Ti and a system consisting of Sr, La, Cu and at least one element selected from a group comprising Al, Fe, Ni, Zn, Ag and Ti.

The present invention is also applicable to the other type superconductor consisting mainly of a compound oxide represented by the formula:

$$\Theta_4(\Phi_{1-q},Ca_q)_mCu_nO_{p+r}$$

in which $\Theta$ stands for Bi or Tl, $\Phi$ stands for Sr when $\Theta$ is Bi and stands for Ba when $\Theta$ is Tl, m and n are numbers each satisfying ranges of $6 \leq m \leq 10$ and $4 \leq n \leq 8$ respectively, $p = (6+m+n)$, q is a number which satisfies a range of $0 < q < 1$, and r is a number which satisfies a range of $-2 \leq r \leq +2$. This system is considered to be a single phase of the following compound oxide or a mixed phase consisting mainly thereof:

$Bi_4Sr_4Ca_4Cu_6O_{20-r}$, $Bi_2Sr_2Ca_2Cu_3O_{10-r}$,
$Tl_4Ba_4Ca_4Cu_6O_{20-r}$, $Tl_2Ba_2Ca_2Cu_3O_{10-r}$,

in which r is a number which satisfies a range of $-2 \leq r \leq +2$.

According to the present invention, the ion to be doped in the superconducting thin film which is prepared by sputtering technique or the like is hydrogen which has a smaller ion diameter and hence can penetrate into the thin film at an increase depth.

In case of the compound oxide type superconductor, the superconductivity can not be realized if any one of crystal structure, composition and oxygen deficiency of the compound oxide do not fall within a predetermined proper range which is relatively narrow. Therefore, when the ion is doped in the thin film of superconductor, the crystal structure of the thin film is transformed or modified or broken and/or the composition thereof is deviated from the proper range, resulting in that the doped portion of the thin film is transformed or changed to non-superconductor. In other words, a superconducting circuit can be produced by the conventional masking technique in which a predetermined portion of the thin film where the circuit, for example a wiring line, is drawn is covered with a suitable mask for example by photo resist before the thin film is exposed to the irradiation of ion. It is also possible to draw the superconducting circuit directly on the superconducting thin film by directing a focused or narrow ion beam onto a predetermined portion of the thin film and by moving it along a predetermined pattern on the thin film where the circuit pattern is not drawn.

According to a preferred embodiment, the thin film is further heat-treated before and/or after the ion is doped or during the ion doping into the thin film of superconductor.

As mentioned above, the superconductivity of compound oxide can not be realized if any one of crystal structure, composition and oxygen deficiency in the compound oxide do not fall within a predetermined proper range which is relatively narrow. It is found that, when the thin film of superconductor is prepared by sputtering technique, the stability and performance as the superconductor of the thin film deposited can be improved by the heat-treatment. Therefore, it is preferable to heat-treat the thin film of superconductor of compound oxide after the film is deposited.

The heat-treatment of the superconducting thin film prepared by sputtering technique or the like may be carried out after irradiation onto or doping into the thin film. The ion to be doped is hydrogen ion. If the hydrogen ion is doped and then the doped thin film is heat-treated, a doped portion of the compound oxide is chemically reduced so that the superconductivity is lost. Ion doping of metals such as Ni, Ti, Zr, Fe or Nb followed by the heat-treatment also disturb realization of superconductivity because metal elements in the compound oxide are substituted by the doped metal ions.

The heat-treatment may be carried out also before the ion doping. In this case, nitrogen ion or oxygen ion may be doped after the heat-treatment. When the oxygen ion is doped in the thin film of superconducting compound oxide, the contents of oxygen in the compound oxide increase excessively, resulting in that the oxygen deficiency in the crystal structure of the thin film deviate from the proper or optimum range thereof and hence the superconductivity is lost and the doped portion is changed to an insulator, so that difference in physical properties between the doped portion and the undoped portion become much clear.

The heat-treatment may be effected in an atmosphere containing oxygen at a temperature of more than 500 °C for more than 3 hours at the partial pressure of oxygen which is higher than $10^4$ Pa (0.1 atm), preferably higher than $10^5$ Pa (1 atm).

In conclusion, the resulting superconducting circuit pattern has a high Tc and Tcf and hence can be used in any cryogen such as liquidized nitrogen which is easily available, so that the circuit is applicable to a variety of devices used in the field of electronics. This advantageous merit is obtained by the method according to the present invention which permit to leave a superconducting pattern of compound oxide having the perovskite type or quasi-perovskite type crystal structure only in a predetermined portion of the substrate.

Now, the present invention will be described with reference to attached drawings which illustrate an apparatus used for carrying out the present invention and a procedure for producing a superconducting circuit pattern according to the present invention but are not limitative of the present invention.

Brief Description of the drawing

FIG. 1 is an illustrative view of a RF (radio-frequency) type ion irradiation apparatus which is used in the present invention.

FIG. 2 is an illustrative view of a circuit pattern produced in an embodiment of the present invention.

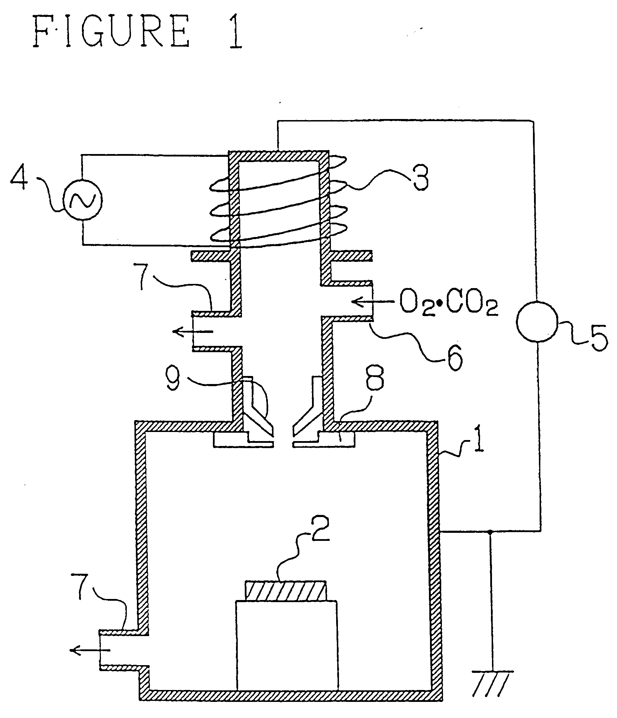

Referring to FIG. 1 which illustrates a RF type plasma ion irradiation apparatus including a chamber 1 and an ion source arranged on the chamber 1 and comprising a high-frequency coil 3, a high-frequency power source 4, an electrostatic lens 8 and an ion draw-out electrode 9. The chamber 1 is provided with a vacuum port 7 connected to a vacuum source (not shown) and a gas inlet port 6 for introducing a gas to be ionized into the ion source.

A superconducting thin film of compound oxide 2 may be deposited on the substrate by means of the conventional sputtering technique.

In operation, after a substrate having the thin film of compound oxide type superconductor 2 whose surface is covered or uncovered with a mask is placed in the chamber 1, vacuum is created in the chamber 1 and in the ion source and then a gas to be ionized is introduced into the ion source. If the ion is produced from a material of solid metal or liquid, such material is evaporated in a crucible placed in the chamber. Then, high-frequency power is applied to the high-frequency coil of the ion source and an acceleration voltage is imposed on the ion drawing-out electrode so that ionized gas or an ionized atoms in a form of a focused or non-focused beam is drawn out of the ion source and is directed onto the thin film of compound oxide 2.

When the ion beam is not converged in a form of a narrow ion beam in order to irradiate the whole surface of the thin film of compound oxide 2 uniformly, a predetermined portion of a surface of the thin film 2 is covered previously with a patterned mask provided by a pellicle or photo resist. Therefore, only naked portions or non-masked portions of the thin film of compound oxide type superconductor is doped with the ion and is transformed to an insulator.

When the ion beam is converged into a narrow ion beam, the mask is not necessary. In this case, the focused ion beam is scanned along a predetermined pattern on the thin film of compound oxide so that a patterned circuit of superconductor is left at the non scanned portions on the thin film.

Now, the method according to the present invention will be described with reference to illustrative Examples, but the scope of the present invention should not be limited thereto.

Example 1 (not belonging to the invention)

A thin film of compound oxide type superconductor was produced by a conventional RF type sputtering machine. Namely, at first, powders of $Y_2O_3$ and $BaCO_3$ were mixed at an atomic ratio of Y : Ba = 1 : 2 and then a powder of CuO was added to the resulting powder mixture at an atomic ratio of Y : Ba : Cu = 1 : 2 : 3. Then, the resulting powder mixture was sintered at 940 °C to obtain a sintered block of $YBa_2Cu_3O_7$ having a dimension of 20 × 30 × 3 mm.

Then, a thin film of compound oxide type superconductor having a thickness of 300 nm is deposited on a substrate consisting of a single crystal of MgO by using the sintered block of Y-Ba-Cu-O type compound oxide as a target in a sputtering machine. The resulting thin film deposited is further heat-treated in oxygen containing atmosphere to obtain a superconducting thin film whose resistance become zero at 95 K.

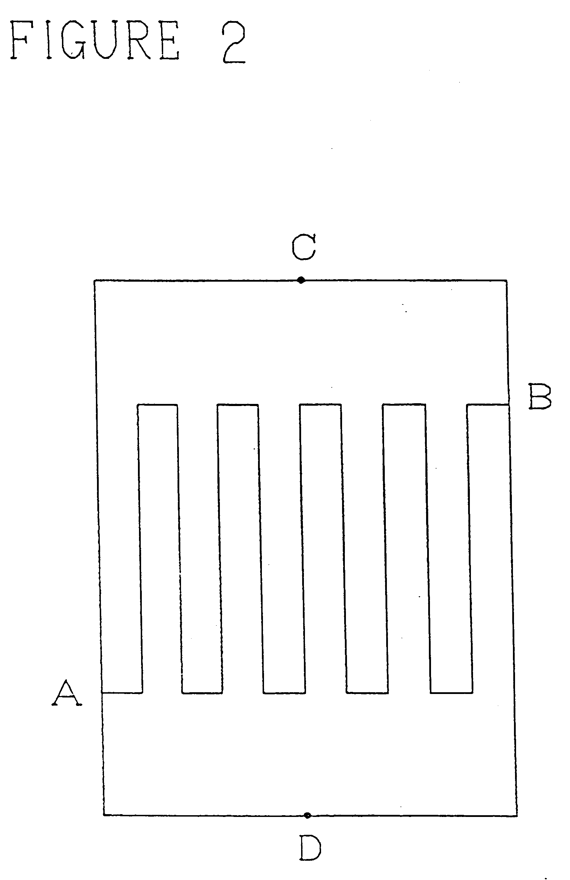

A surface of the superconducting thin film of compound oxide is covered with photo resist so that a circuit pattern shown in Fig. 2 only is left in an area of 5 × 5 mm on the thin film of compound oxide.

After the substrate having the masked thin film 2 is placed in the chamber 1, the pressure in the chamber 1 was reduced to $1,3 \times 10^{-5}$ Pa ($10^{-7}$ Torr), argon gas of 0,13Pa ($10^{-3}$ Torr) was introduced into the ion source. Then, the high-frequency coil is energized so that the argon ion having an energy of 300 keV is produced. The argon ion is directed to and is doped in the thin film in the amount of 5 × $10^{16}$/cm$^2$.

After the photo resist is removed, Tc and Tcf are measured. The result is that the resistance of the undoped portion corresponding to the superconducting circuit pattern become zero at 80 K, while the doped portion is transformed to an insulator which does not show any superconductivity in a temperature range between ambient temperature to 4 K.

Example 2 (not belonging to the invention)

A thin film having a thickness of 300nm of La-Sr-Cu-O system compound oxide is prepared by sputtering technique by using a target of a sintered block of $(La, Sr)_2CuO_4$ on a substrate consisting of a single crystal of $SrTiO_3$. The thin film is further heat-treated in oxygen containing atmosphere.

The same procedure as Example 1 is repeated except that He ion is used as a dopant to be doped in the superconducting thin film. The helium ion of 100 keV is doped in the thin film in the amount of 1 × $10^{18}$/cm$^2$ to produce the same circuit pattern as Example 1.

Table 1 shows the operation condition and the measured Tc of the circuit pattern.

Example 3

A thin film having a thickness of 300 nm of La-Ba-Cu-O system compound oxide is prepared by sputtering technique by using a target of a sintered block of $LaBa_2Cu_3O_7$ on a substrate consisting of a single crystal of $SrTiO_3$. The thin film is further heat-treated in oxygen containing atmosphere.

The same procedure as Example 1 is repeated except that $H_2$ ion is doped in the superconducting thin film. The hydrogen ion of 80 keV is doped in the thin film in the amount of 2 × $10^{18}$/cm$^2$ to produce the same circuit pattern as Example 1.

Table 1 shows the operation condition and the measured Tc of the circuit pattern.

Example 4 (not belonging to the invention)

A thin film having a thickness of 300nm of Y-Ba-Cu-O system compound oxide is prepared by sputtering technique by using a target of a sintered block of $YBa_2Cu_3O_7$ on a substrate consisting of a single crystal of $LiNbO_3$. The thin film is further heat-treated in oxygen containing atmosphere.

The same procedure as Example 1 is repeated except that $O^+$ ion is doped in the superconducting thin film to produce a circuit pattern. The oxygen ion having energy of 150 keV is doped in the thin film in the amount of 5 × $10^{17}$/cm$^2$.

Table 1 shows the operation condition and the measured Tc of the circuit pattern.

Example 5

A thin film of compound oxide type superconductor was produced by a conventional RF type sputtering machine. Namely, at first, powders of $Y_2O_3$, $BaCO_3$ and CuO were mixed at an atom ratio of Y : Ba : Cu = 1 : 2: 3. Then, the resulting powder mixture was sintered at 940 °C to obtain a sintered block of $YBa_2Cu_3O_7$ having a dimension of 20 × 30 × 3 mm.

Then, a superconducting thin film of compound oxide having a thickness of 450nm is deposited on a substrate consisting of a single crystal of MgO by using the resulting sintered block of Y-Ba-Cu-O type compound oxide as a target in a sputtering machine. The resulting thin film deposited is further heat-treated in oxygen containing atmosphere to obtain a superconducting thin film.

A surface of the thin film of superconducting compound oxide is covered with photo resist by a well-known process in the field of semiconductor and a circuit pattern shown in Fig. 2 is left in an area of 5 × 5 mm on the thin film of compound oxide.

After the substrate having the thin film 2 masked with photo resist is placed in the chamber 1, the pressure in the chamber 1 was reduced to $1,3 \times 10^{-5}$ Pa ($10^{-7}$ Torr) and $H_2$ gas of 0,13Pa ($10^{-3}$ Torr) was introduced into the ion source. Then, the high-frequency coil is energized by high-frequency at a power of 50 W while a potential is applied to the ion drawing-out electrode so that the hydrogen ion having an energy of 100 keV is doped in the thin film in the amount of $2 \times 10^{18}$/cm$^{2.}$

Then, the resulting thin film is further heat-treated in air at 920 °C for 20 hours. After this heat-treatment, the oxygen contents in a $H^+$ ion doped portion in the thin film decrease by 20 % in comparison with an undoped portion of the film.

After the photo resist is removed, Tc and Tcf are measured. The result is that the resistance of the undoped circuit pattern portion become zero at 82 K, while doped portion is transformed to an insulator whose resistance do not become zero in a temperature range between from ambient temperature to 4 K.

Example 6 (not belonging to the invention)

A thin film of compound oxide type superconductor having a thickness of 300nm is deposited on a substrate consisting of a single crystal of $LiNbO_3$ by using the same sintered block of Y-Ba-Cu-O type compound oxide as Example 5 as a target in a sputtering machine. The resulting thin film deposited is further heat-treated in oxygen containing atmosphere.

The same procedure as Example 5 is repeated except that $O^+$ ion is doped in the superconducting thin film so that the oxygen ion of an energy of is 200 keV is doped in the thin film in the amount of $5 \times 10^{18}$/cm$^{2.}$

After this doping, the oxygen contents in a $O^+$ ion doped portion in the thin film increase by 25 % in comparison with an undoped portion of the film.

Table 1 shows the operation condition and the measured Tc of the circuit pattern.

Example 7 (not belonging to the invention)

A thin film of compound oxide type superconductor was produced by a conventional RF type sputtering machine. Namely, at first, powders of $La_2O_3$, $BaCO_3$ and CuO were mixed at an atomic ratio of La : Ba : Cu = 1 : 2: 3. Then, the resulting powder mixture was sintered at 940 °C to obtain a sintered block of $LaBa_2Cu_3O_7$ having a dimension of 20 × 30 × 3 mm.

Then, a thin film of compound oxide type superconductor having a thickness of 300nm is deposited on a substrate consisting of a single crystal of $SrTiO_3$ by using the sintered block of La-Ba-Cu-O type compound oxide as a target in a sputtering machine.

A surface of the thin film of superconducting compound oxide is covered with photo resist and a circuit pattern shown in Fig. 2 is left naked in an area of 5 × 5 mm on the thin film of compound oxide.

After the substrate having the masked thin film 2 is placed in the chamber 1, the pressure in the chamber 1 was reduced to $1,3 \times 10^{-5}$ Pa ($10^{-7}$ Torr), $Ni^+$ ion of 250 keV is doped in the film in the amount of $1 \times 10^{18}$/cm$^{2.}$

Then, the resulting thin film is heat-treated in air at 880 °C for 18 hours. After this heat-treatment, the resistance of the undoped circuit pattern portion become zero at 80 K, while $Ni^+$ ion doped portion is transformed to an insulator whose resistance do not become zero in a temperate range between ambient temperature to 4 K.

Table 1 shows the operation condition and the measured Tc of the circuit pattern.

Example 8 (not belonging to the invention)

The same procedure as Example 1 was repeated except that powders of $Bi_2O_3$, $SrCO_3$, CaO and CuO were mixed at an atomic ratio of Bi : Sr : Ca : Cu = 2 : 2 : 2 : 3 and then sintered at 880 °C to obtain a sintered block of $Bi_4Sr_4Ca_4Cu_6O_{20}$.

A thin film of Bi-Sr-Ca-Cu system compound oxide is prepared on a substrate consisting of a single crystal of $SrTiO_3$ by using the resulting sintered block as a target in a sputtering machine. The deposited thin film is further heat-treated to obtain a superconducting thin film of the Bi-Sr-Ca-Cu system compound oxide.

The same ion irradiation procedure as Example 1 is repeated except that the superconducting thin film is doped with Ar ion of 200 keV in the amount of of $2 \times 10^{17}/cm^2$.

Table 1 shows the operation condition and the measured Tc of the circuit pattern.

## Table 1

| No. | Compound oxide system | Substrate material | Doped Ion | | | Tc of the Circuit pattern (K) | |
|---|---|---|---|---|---|---|---|
| | | | Ion | Energy (keV) | Amount doped (/cm²) | | |
| 1 | Y-Ba-Cu-O | MgO | $Ar^+$ | 300 | $5 \times 10^{16}$ | 80 | * |
| 2 | La-Sr-Cu-O | $SrTiO_3$ | $He^+$ | 100 | $1 \times 10^{18}$ | 28 | * |
| 3 | La-Ba-Cu-O | $SrTiO_3$ | $H_2^+$ | 80 | $2 \times 10^{18}$ | 35 | |
| 4 | Y-Ba-Cu-O | $LiNbO_3$ | $O^+$ | 150 | $5 \times 10^{17}$ | 85 | * |
| 5 | Y-Ba-Cu-O | MgO | $H^+$ | 100 | $2 \times 10^{18}$ | 82 | |
| 6 | Y-Ba-Cu-O | $LiNbO_3$ | $O^+$ | 200 | $5 \times 10^{18}$ | 78 | * |
| 7 | La-Ba-Cu-O | $SrTiO_3$ | $Ni^+$ | 250 | $1 \times 10^{18}$ | 33 | * |
| 8 | BiSrCaCuO | $SrTiO_3$ | $Ar^+$ | 200 | $2 \times 10^{17}$ | 101 | * |

* not belonging to the invention

## Claims

1. A method for producing a superconducting circuit comprising the steps of
depositing a thin film of superconductor of compound copper oxide on a substrate and
doping a selected portion on a surface of said thin film, characterized in that said step of doping is doping with hydrogen ions in a dose of more than $1 \times 10^8$ atoms/cm² at a doping energy higher than 20 keV and up to and including 100 keV, to transform the crystal structure of the thin film at the selected portion from superconductor to non-superconductor, so that the remaining portion of the thin film which is left undoped in the condition of superconductor functions as a superconducting circuit.

**2.** The method set forth in Claim 1, characterized in that the thin film of superconductor is prepared by the physical vapour deposition technique.

**3.** The method set forth in Claim 1 or 2, wherein the ions are emitted from one of ion sources of Freeman type, Kaufman type, PIG type, RF (radio-frequency) type or a microwave plasma type.

**4.** The method set forth in any one of Claims 1 to 3 wherein said compound copper oxide is composed of an element $\alpha$ selected from IIa group, an element $\beta$ selected from IIIa group, copper and oxygen.

**5.** The method set forth in Claim 4, wherein said compound copper oxide is represented by the formula :

$$(\alpha_{1-x}\beta_x)CU_yO_z$$

in which $\alpha$ and $\beta$ means the same definition as above, x is an atomic ratio of $\beta$ with respect to $(\alpha + \beta)$ and has a range of $0.1 \leq x \leq 0.9$, and y and z are respective atomic ratios with respect to $(\alpha_{1-x}\beta_x)$ which is considered to be equal to 1 and each satisfing ranges of $0.4 \leq y \leq 3.0$ and $1 \leq z \leq 5$ respectively.

**6.** The method set forth in Claim 5, wherein said element $\alpha$ is Ba and said element $\beta$ is at least one element selected from a group comprising Y, La, Gd, Dy, Ho, Er, Tm, Yb, Nd, Sm, Eu and Lu.

**7.** The method set forth in Claim 5 wherein said element $\alpha$ is Sr and said element $\beta$ is La.

**8.** The method set forth in any one of Claims 1 to 3, wherein said superconductor compound copper oxide is represented by the formula :

$$\Theta_4(\Phi_{1-q},Ca_q)_mCu_nO_{p+r}$$

in which $\Theta$ stands for Bi or Tl, $\Phi$ stands for Sr when $\Theta$ is Bi and stands for Ba when $\Theta$ is Tl, m and n are numbers each satisfying ranges of $6 \leq m \leq 10$ and $4 \leq n \leq 8$ repectively, $p = (6+m+n)$, q is a number which satisfies a range of $0 < q < 1$, and r is a number which satisfies a range of $-2 \leq r \leq + 2$.

**9.** The method set forth in any one of Claims 1 to 8, wherein said thin film is further heat-treated before, during and/or after the ion doping.

## Patentansprüche

**1.** Verfahren zur Herstellung einer supraleitenden Schaltung, umfassend die Verfahrensschritte des Abscheidens einer dünnen Schicht eines Supraleiters aus einer Kupferoxidverbindung auf einem Substrat und des Dotierens eines ausgewählten Bereichs der Oberfläche der dünnen Schicht, dadurch gekennzeichnet, daß der Verfahrensschritt des Dotierens aus einem Dotieren mit Wasserstoffionen mit einer Menge von mehr als $1 \times 10^8$ Atomen/cm$^2$ bei einer Dopingenergie von mehr als 20 keV bis und einschließlich 100 keV besteht, um die Kristallstruktur der dünnen Schicht des ausgewählten Bereichs vom supraleitenden in den nicht-supraleitenden Zustand umzuwandeln, so daß der verbleibende Bereich der dünnen Schicht, der nicht dotiert wird, im supraleitenden Zustand verbleibt und als supraleitende Schaltung wirkt.

**2.** Verfahren nach Anspruch 1, dadurch gekennzeichnet, daß die dünne supraleitende Schicht durch eine physikalische Dampfabscheidetechnik hergestellt wird.

**3.** Verfahren nach Anspruch 1 oder 2, bei dem die Ionen von einer Ionenquelle vom Freeman-Typ, Kaufman-Typ, PIG-Typ, RF (Radiofrequenz)-Typ oder Mikrowellen-Plasmatyp erzeugt werden.

**4.** Verfahren nach einem der Ansprüche 1 bis 3, bei dem die Kupferoxidverbindung aus einem Element $\alpha$, das ausgewählt ist aus der IIa-Gruppe, einem Element $\beta$, das ausgewählt ist aus der IIIa-Gruppe, Kupfer und Sauerstoff besteht.

10

**5.** Verfahren nach Anspruch 4, bei dem die Kupferoxidverbindung durch die Formel:

$$(\alpha_{1-x}\beta_x)CU_yO_z$$

dargestellt wird, wobei $\alpha$ und $\beta$ dieselbe Definition wie oben zukommt, x das Atomverhältnis von $\beta$ bezüglich $(\alpha + \beta)$ ist und im Bereich von $0,1 \leq x \leq 0,9$ liegt und y und z entsprechende Atomverhältnisse bezüglich $(\alpha_{1-x}\beta_x)$ sind, die gleich 1 angesehen werden, wobei sie in den Bereichen von $0,4 \leq y \leq 3,0$ bzw. $1 \leq z \leq 5$ liegen.

**6.** Verfahren nach Anspruch 5, bei dem das Element $\alpha$ Ba ist und das Element $\beta$ wenigstens eines der Elemente ist, das ausgewählt ist aus einer Gruppe, welche Y, La, Gd, Dy, Ho, Er, Tm, Yb, Nd, Sm, Eu und Lu umfaßt.

**7.** Verfahren nach Anspruch 5, bei dem das Element $\alpha$ Sr ist und das Element $\beta$ La ist.

**8.** Verfahren nach einem der Ansprüche 1 bis 3, bei dem die supraleitende Kupferoxidverbindung durch die folgende Formel dargestellt wird:

$$\theta_4(\Phi_{1-q},Ca_q)_mCu_nO_{p+r},$$

bei dem $\theta$ für Bi oder Tl steht, $\Phi$ für Sr steht, wenn $\theta$ Bi ist und für Ba steht, wenn $\theta$ Tl ist, m und n Zahlen sind, welche in den Bereichen $6 \leq m \leq 10$ bzw. $4 \leq n \leq 8$ liegen, $p = (6+m+n)$ ist, q eine Zahl ist, welche im Bereich $0 < q < 1$ liegt und r eine Zahl ist, welche im Bereich $-2 \leq r \leq +2$ liegt.

**9.** Verfahren nach einem der Ansprüche 1 bis 8, bei dem die dünne Schicht vor, während und/oder nach dem Dotieren mit Ionen wärmebehandelt wird.

**Revendications**

**1.** Procédé de production d'un circuit supraconducteur comprenant les étapes consistant à :
déposer un film mince de supraconducteur d'oxyde de cuivre composé sur un substrat et
doper une partie choisie située sur une surface dudit film mince,
caractérisé en ce que ladite étape de dopage est constituée d'un dopage à l'aide d'ions hydrogène selon une dose de plus de $1 \times 10^8$ atomes/cm$^2$ à une énergie de dopage plus élevée que 20 keV et allant jusqu'à 100 keV compris, pour transformer la structure cristalline du film mince au niveau de la partie choisie à partir d'une structure supraconductrice vers une structure non supraconductrice, de telle sorte que la partie restante du film mince qui est laissée non dopée dans l'état de supraconductivité agit comme un circuit supraconducteur.

**2.** Procédé selon la revendication 1, caractérisé en ce que le film mince de supraconducteur est préparé par la technique de dépôt en phase vapeur par procédé physique.

**3.** Procédé selon la revendication 1 ou 2, dans lequel les ions sont émis à partir de l'une des sources d'ions du type Freeman, du type Kaufman, du type PIG, du type RF (fréquence radio) ou du type plasma micro-onde.

**4.** Procédé selon l'une quelconque des revendications 1 à 3, dans lequel ledit oxyde de cuivre composé est composé d'un élément $\alpha$ choisi parmi le groupe IIa, d'un élément $\beta$ choisi parmi le groupe IIIa, de cuivre et d'oxygène.

**5.** Procédé selon la revendication 4, dans lequel ledit oxyde de cuivre composé est représenté par la formule :

$$(\alpha_{1-x}\beta_x)Cu_yO_z$$

dans laquelle $\alpha$ et $\beta$ indiquent la même définition que ci-dessus, x est un rapport atomique de $\beta$ par rapport à $(\alpha + \beta)$ et est situé dans une plage telle que $0,1 \leq x \leq 0,9$, et y et z sont les rapports atomiques respectifs par rapport à $(\alpha_{1-x}\beta_x)$ qui est considéré comme étant égal à 1 et qui sont chacun

11

dans des plages telles que $0,4 \leqq y \leqq 3,0$ et $1 \leqq z \leqq 5$, respectivement.

**6.** Procédé selon la revendication 5, dans lequel ledit élément $\alpha$ est Ba et ledit élément $\beta$ est au moins un élément choisi parmi un groupe constitué de Y, La, Gd, Dy, Ho, Er, Tm, Yb, Nd, Sm, Eu et Lu.

**7.** Procédé selon la revendication 5, dans lequel ledit élément $\alpha$ est Sr et ledit élément $\beta$ est La.

**8.** Procédé selon l'une quelconque des revendications 1 à 3, dans lequel ledit oxyde de cuivre composé supraconducteur est représenté par la formule :

$$\Theta_4 (\Phi_{1-q}, Ca_q)_m Cu_n O_{p+r}$$

dans laquelle $\Theta$ indique Bi ou Ti, $\Phi$ indique Sr lorsque $\Theta$ est Bi et indique Ba lorsque $\Theta$ est Ti, m et n sont des nombres situés chacun dans les plages respectivement telles que $6 \leqq m \leqq 10$ et $4 \leqq n \leqq 8$, p $= (6 + m + n)$, q est un nombre qui est situé dans une plage telle que $0 < q < 1$, et r est un nombre qui est situé dans une plage telle que $-2 \leqq r \leqq +2$.

**9.** Procédé selon l'une quelconque des revendications 1 à 8, dans lequel ledit film mince est en outre traité thermiquement avant, pendant et/ou après le dopage ionique.

12

# FIGURE 1

# FIGURE 2